# FASCICULE DE BREVET EUROPEEN

(11) **EP 1 886 540 B1**
(45) Date de publication et mention de la délivrance du brevet: **11.08.2010**
(21) Numéro de dépôt: 06755219.0
(22) Date de dépôt: 16.05.2006
(51) Int. Cl.: H05B 33/26, H01J 1/88, G09F 9/33, H01L 27/15

(54) **PANNEAU ELECTROLUMINESCENT D'ECLAIRAGE OU D'AFFICHAGE D'IMAGES DOTEE D'UNE ELECTRODE SUPERIEURE TRANSPARENTE COMPOSITE**
LEUCHTSCHIRM ZUM BELEUCHTEN ODER ANZEIGEN VON BILDERN MIT EINER ZUSAMMENGESETZTEN TRANSPARENTEN OBEREN ELEKTRODE
LIGHT-EMITTING PANEL FOR ILLUMINATING OR DISPLAYING IMAGES PROVIDED WITH A COMPOSITE TRANSPARENT UPPER ELECTRODE

(30) Priorité: 23.05.2005 FR 0551338
(43) Date de publication de la demande: 13.02.2008
(73) Titulaire: Thomson Licensing, 92130 Issy-les-Moulineaux (FR)
(72) Inventeur: HAAS, Gunther, 38120 Saint Egrève (FR); RACINE, Benoit, 38140 Renage (FR); VAUFFREY, David, F-38000 Grenoble (FR)
(74) Mandataire: Browaeys, Jean-Philippe
(86) Numéro de dépôt international: PCT/EP2006/062355
(87) Numéro de publication internationale: WO 2006/125735

(56) Documents cités:
- EP-A- 0 838 976
- EP-A- 0 977 286
- WO-A-2004/049465
- US-A- 5 739 545

## Description

L'invention concerne les panneaux d'éclairage ou d'affichage d'images comprenant un réseau de diodes organiques électroluminescentes supportées par un substrat.

L'art antérieur décrit de tels panneaux, où chaque diode comprend une couche organique électroluminescente intercalée entre une électrode inférieure au contact du substrat et une électrode supérieure qui est transparente à la lumière émise par cette couche organique électroluminescente. Il s'agit donc de ce qu'on appelle des panneaux à « émission vers le haut ». Selon les cas, les électrodes supérieures sont des cathodes (structure de diode dite « classique ») ou des anodes (structure dite « inverse »).

Entre les électrodes, on trouve généralement d'autres couches organiques, telles que des couches d'injection et de transport de trous ou d'électrons, et/ou des couches d'optimisation d'extraction de lumière, notamment par effet de résonance dans les cavités optiques entre les électrodes.

L'art antérieur décrit également de tels panneaux, où des électrodes supérieures sont communes à au moins une pluralité de diodes et comprennent une couche d'oxyde conducteur, généralement un oxyde mixte d'indium et d'étain (ITO) ou un oxyde mixte d'indium et de zinc (IZO).

La fabrication d'un tel panneau requiert le dépôt de la couche d'oxyde conducteur en ITO au dessus des couches organiques. Or, il est connu que les conditions usuelles d'un tel dépôt, notamment les conditions thermiques ou l'application d'un plasma de pulvérisation cathodique, risquent de dégrader les couches organiques sous-jacentes.

Pour éviter ou limiter ce risque, l'art antérieur présente de nombreuses solutions.

Le document US 5969474 propose d'insérer une couche tampon entre les couches organiques des diodes et la couche transparente en oxyde conducteur ; cette couche tampon est destinée à protéger les couches organiques pendant le dépôt de la couche en oxyde conducteur, notamment à éviter son oxydation. Comme matériau de couche tampon, ce document propose un matériau conducteur métallique à base de titane, de chrome ou de tantale, ou un nitrure de ce métal. Ainsi, dans les panneaux décrits dans ce document, des électrodes supérieures sont communes à une pluralité des diodes et comprennent une première couche conductrice métallique d'épaisseur inférieure ou égale à 20 nm, et une deuxième couche conductrice en ITO ou IZO, en contact avec cette première couche ; cette deuxième couche présente généralement une épaisseur supérieure ou égale à 50 nm, donc supérieure à celle de la première couche. A noter que l'épaisseur de cette couche tampon reste très faible, c'est-à-dire inférieure à 20 nm ; lorsqu'on utilise spécifiquement des nitrures (exemple 2 de ce document), l'épaisseur n'est alors que de 5 nm pour maintenir une conductivité et une transparence suffisamment élevée.

Le document WO 2004/049465 indique que de telles couches tampons métalliques doivent être suffisamment épaisses (> 30 nm) pour être efficaces en protection, mais qu'à cause de cette épaisseur importante, l'électrode supérieure perd alors significativement de sa transparence, ce qui est préjudiciable au rendement lumineux. Ce document propose de doper avec du SiO ces couches métalliques tampons pour les rendre plus efficaces en protection et plus transparentes.

Les documents US 6172459 et US 6140763 divulguent des matériaux de couches tampons relativement épaisses à base de composés organiques prophyriniques, qui présentent l'avantage d'être conducteurs, protecteurs et transparents.

Un but de l'invention est d'apporter une solution différente et plus économique pour limiter les risques de dégradation des couches organiques lors du dépôt d'électrodes supérieures transparentes.

A cet effet, l'invention a pour objet un panneau d'éclairage ou d'affichage d'images comprenant un réseau de diodes organiques électroluminescentes supportées par un substrat, au moins un réseau d'électrodes inférieures au contact du substrat et un réseau d'électrodes supérieures, où chaque diode comprend une couche organique électroluminescente qui est intercalée entre une électrode inférieure et une électrode supérieure, qui elle-même est transparente à la lumière émise par cette diode,
où au moins une desdites électrodes supérieures est commune à une pluralité de diodes et comprend une première couche conductrice et une deuxième couche conductrice, et une couche tampon isolante et transparente intercalée entre ces deux couches conductrices, où, la zone active de chaque diode étant définie comme la surface de couche organique électroluminescente de cette diode qui est au contact direct à la fois d'une électrode inférieure et d'une électrode supérieure, pour chaque dite électrode supérieure commune à une pluralité de diodes, ladite couche tampon est percée de fenêtres qui ménagent des zones de contact direct entre les deux couches conductrices de cette électrode commune, ces zones de contact étant disjointes des zones actives des diodes de ladite pluralité.

Les fenêtres de la couche tampon sont en général des ouvertures ou « trous » pratiqués dans cette couche ; à noter que, dans les panneaux décrits dans les documents US 6172459 et US 6140763, les couches tampon ne présentent pas de fenêtres ou ouvertures ni donc de zones où les deux couches conductrices de l'électrode supérieure sont en contact direct l'une avec l'autre, sans couche tampon intermédiaire ; en effet, un tel contact direct n'est pas nécessaire pour établir un pont conducteur puisque la couche tampon elle-même est conductrice ; il n'y a pas davantage de fenêtres ou ouvertures pratiquées dans les couches tampon décrites dans le document US5739545, notamment en ZnSe ou ZnS, puisque, là aussi, les couches tampon sont conductrices au travers de ses joints de grains.

La première couche conductrice de chaque électrode supérieure commune à plusieurs diodes est au contact de la couche organique électroluminescente.

La zone active de chaque diode est définie plus précisément comme la zone de superposition de l'électrode inférieure et de l'électrode supérieure de cette diode ; c'est donc uniquement dans cette zone de superposition que la couche organique électroluminescente est soumise à un champ électrique quand la diode est mise sous tension et émet de la lumière ; en dehors de ces zones actives, il n'y a donc pas d'émission de lumière.

Chaque zone de recouvrement, c'est-à-dire de croisement ou de superposition, d'une électrode inférieure et d'une électrode supérieure, correspond donc à une diode ; la zone active de cette diode correspond donc à la surface de couche organique électroluminescente de cette diode qui est au contact direct à la fois de cette électrode inférieure et de cette électrode supérieure, qui est apte à transmettre la lumière émise par cette diode.

De préférence, pour chaque électrode supérieure, lesdites zones de contact direct ne se superposent avec aucune zone active des diodes ayant une électrode supérieure en commun ; ce qui signifie que les fenêtres ou ouvertures pratiquées dans la couche tampon, qui correspondent aux zones de contact entre les deux couches conductrices de l'électrode supérieure considérée, sont situées en dehors des zones actives ; ainsi, si le dépôt de la deuxième couche conductrice à l'endroit de ces zones de contact engendre une dégradation des couches organiques éventuelles sous-jacentes, une telle dégradation n'est pas gênante puisqu'elle intervient en dehors des zones actives des diodes.

La couche organique électroluminescente des diodes peut être commune à plusieurs diodes. Le réseau d'électrodes supérieures peut ne comporter qu'une seule électrode qui est alors commune à toutes les diodes.

Les diodes du panneau sont à émission « vers le haut » car les électrodes supérieures sont transparentes, au moins aux emplacements des diodes. Ces électrodes peuvent être également semi-transparentes, par exemple pour modifier la colorimétrie d'émission intrinsèque des diodes, et/ou pour ajuster les effets de cavité optique entre les électrodes de manière à améliorer l'extraction de lumière.

De préférence, la couche tampon présente un caractère isolant ; de préférence, pour chaque dite électrode supérieure, la conductivité surfacique de la couche tampon est inférieure à un dixième de la conductivité surfacique de la deuxième couche conductrice de cette électrode supérieure ; la conductivité surfacique d'une couche signifie la conductivité d'un élément carré de surface de cette couche ; ainsi, dans le cas d'une couche tampon en matériau à base de nitrure comme dans l'exemple 2 du document US5969474, l'épaisseur de la couche tampon sera largement supérieure à 5 nm ; c'est précisément du fait de la faible conductivité surfacique de la couche tampon que des zones de contact direct entre les deux couches conductrices de l'électrode supérieure sont nécessaires, pour assurer un pont de conduction ; à noter que, dans le document US5739545, le pontage conducteur entre les deux couches conductrices de l'électrode supérieure est assurée au travers de la couche tampon intermédiaire (ZnSe notamment) et non pas par des zones de contact direct comme dans l'invention ; de préférence, pour chaque électrode supérieure commune, la conductivité surfacique de la couche tampon est inférieure à la conductivité surfacique de la première couche conductrice de cette électrode ; de préférence, la conductivité surfacique de la couche tampon est inférieure à un dixième de la conductivité surfacique de la première couche conductrice. Pour la couche tampon, on peut utiliser des matériaux organiques, du moins s'ils satisfont les critères de faible conductivité ci-dessus : on utilisera par exemple le Spiro TAD, le Spiro TTB, le NPB, le TPD, le BCP, ou le Bphen. Il convie nt que l'épaisseur du matériau organique soit suffisante pour assurer efficacement la fonction de protection des couches organiques sous-jacentes. De préférence, pour chaque électrode supérieure commune, le matériau de la couche tampon est inorganique, ce qui apporte une contribution avantageuse à l'encapsulation des diodes ; de préférence, ce matériau est choisi dans le groupe formé par l'oxyde, le nitrure, et l'oxy-nitrure de silicium, et l'oxyde de tantale : SiOx, SiNy, TaOz., où 0 < x ≤ 2 ; 0 < y ≤ 1,33, 0 < z ≤ 2,5.

Comme la couche tampon est isolante, le courant électrique est transmis entre les deux couches conductrices d'une même électrode supérieure par l'intermédiaire des zones de contact direct qui, selon l'invention, sont situées entre les diodes, plus précisément entre les surfaces actives ou émissives des diodes.

Comme la couche tampon isolante recouvre les zones de contact entre la couche organique électroluminescente et l'électrode inférieure des diodes, cette couche tampon est apte à protéger efficacement les zones actives, c'est-à-dire émissives, des couches organiques pendant le dépôt de la deuxième couche conductrice des électrodes supérieures, notamment lorsque ce dépôt est réalisé dans des conditions énergétiques qui risqueraient de dégrader les couches organiques en l'absence de protection.

Comme la couche tampon isolante est intercalée entre les deux couches conductrices des électrodes supérieures, la première couche conductrice peut être directement au contact de toute la surface des couches organiques, assurer ainsi au sein de ces couches un champ électrique qui est homogène sur toute cette surface, de manière à obtenir une émission électroluminescente homogène sur cette surface.

Selon une variante avantageuse de l'invention, cette couche tampon est partitionnée en éléments tampons disjoints de sorte que les fenêtres ou ouvertures dans la couche tampon forment au contraire une surface continue.

De préférence, pour chaque électrode supérieure commune, le matériau de ladite seconde couche conductrice est à base d' oxyde : il s'agit donc d'oxyde transparent conducteur (« OTC »). De préférence, on utilise l'oxyde mixte d'Indium et d'étain (ITO), ou l'oxyde mixte d'Indium et de Zinc (IZO). Les conditions de dépôt de tels oxydes risqueraient de dégrader les couches organiques en l'absence de la protection apportée par les éléments tampons. Par ailleurs, un avantage à utiliser ces oxydes mixtes est qu'ils protègent efficacement la couche organique électroluminescente des diodes contre les risques de détérioration, notamment par l'oxygène et/ou la vapeur d'eau de l'atmosphère et apportent ainsi une fonction d'encapsulation.

De préférence, l'épaisseur de la deuxième couche conductrice (33) est supérieure ou égale à 100 nm. Une telle épaisseur permet de renforcer la fonction d'encapsulation apportée par la deuxième couche conductrice.

De préférence, pour chaque électrode supérieure commune, le matériau de ladite première couche conductrice est métallique. De préférence, l'épaisseur de cette première couche conductrice est supérieure à 1 nm et inférieure ou égale à 20 nm. Une épaisseur aussi faible permet d'assurer la transparence, notamment lorsque le matériau de cette couche est métallique. Une épaisseur aussi faible permet généralement d'assurer une conductance suffisante sur la surface d'une diode ou de quelques diodes, mais ne permet généralement pas à cette première couche seule d'assurer une conductance suffisante à l'ensemble de l'électrode supérieure lorsqu'elle est commune à une pluralité importante de diodes, ce qui rend d'autant plus utile la deuxième couche conductrice.

De préférence, pour chaque électrode supérieure commune, l'épaisseur de la deuxième couche conductrice est supérieure à l'épaisseur de la première couche conductrice.

De préférence, pour chaque électrode supérieure commune, la conductivité surfacique de la deuxième couche conductrice est supérieure à la conductivité surfacique de la première couche conductrice. Grâce à cette conductivité plus élevée, la deuxième couche assure une distribution uniforme du courant sur toute la surface du panneau.

On entend par conductivité surfacique d'une couche, la conductivité d'un élément carré de surface de cette couche. Ajoutée au choix d'un matériau métallique, donc très conducteur, pour la première couche et d'un matériau à base d'oxyde conducteur, donc peu conducteur, pour la deuxième couche, un tel critère implique que l'épaisseur de la deuxième couche est beaucoup plus élevée que celle de la première couche.

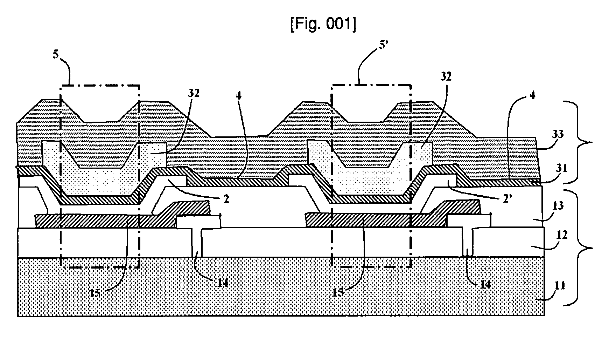

L'invention sera mieux comprise à la lecture de la description qui va suivre, donnée à titre d'exemple non limitatif, et en référence à la figure 1 qui décrit une vue en coupe partielle d'un panneau selon un mode de réalisation de l'invention, où la couche tampon est partitionnée en éléments tampons disjoints.

On part d'un substrat 1, intégrant ici une matrice active, connu en lui-même, dont la fabrication ne sera pas décrite en détail : une plaque rigide 11 en matériau isolant supporte un réseau de circuits de contrôle et d'alimentation de diodes, dits « circuits de pixels », présentant chacun une sortie 14 reliée à une électrode inférieure 15, qui est de préférence métallique et réfléchissante. Cette plaque rigide supporte généralement plusieurs couches électriquement isolantes, dont une première couche d'isolation 12, notamment pour isoler les composants des circuits de pixels entre eux ; et une deuxième couche d'isolation 13, pour séparer les diodes et isoler les électrodes inférieures des électrodes supérieures en dehors des surfaces émissives des diodes. A l'endroit des diodes, cette deuxième couche d'isolation 13 est percée de fenêtres laissant apparaître la surface des électrodes inférieures 15. Enfin, ce substrat intègre d'autres réseaux d'électrodes non représentées, notamment des électrodes pour la commande, par exemple sélection et adressage, des circuits de pixels.

Les électrodes inférieures 15 sont généralement disposées en lignes et en colonnes, selon la disposition des diodes à obtenir sur le panneau.

Sur l'ensemble des électrodes inférieures 15, par une méthode physique de dépôt comme l'évaporation sous vide, on dépose une couche organique électroluminescente. Pour obtenir des couleurs différentes selon les colonnes de diodes, on dépose des couches organiques différentes 2, 2' sur des colonnes adjacentes. A cet effet, on utilise des masques. En pratique, comme représenté sur la figure 1, l'imprécision du positionnement des dépôts provenant du recours à des masques et la nécessité, pour éviter les courts-circuits, de couvrir l'ensemble de la surface des électrodes inférieures 15 dégagées par les fenêtres pratiquées dans la couche isolante 13, conduisent à des dépôts de couches organiques 2, 2' qui débordent largement les limites de ces fenêtres.

Généralement, les couches organiques 2, 2' sont subdivisées en plusieurs sous-couches, notamment des sous-couches d'injection et de transport de charges (électrons ou trous), une sous-couche électroluminescente à proprement parler, et, le cas échéant, des sous-couches de blocage de charges pour limiter les recombinaisons de charges non radiatives. De préférence, pour les sous-couches d'injection et de transport de charges, on utilise des matériaux organiques dopés, qui permettent d'élargir la panoplie de matériaux utilisables pour les électrodes et qui permettent d'augmenter l'épaisseur afin d'obtenir un effet de planarisation.

Après le dépôt des couches organiques, on procède au dépôt d'une première pleine couche conductrice métallique 31 d'épaisseur inférieure ou égale à 20 nm, mais supérieure à 1 nm de manière à recouvrir l'ensemble de la surface active du substrat. Cette première couche conductrice est continue, d'épaisseur approximativement homogène, et sans trous intentionnels ni fenêtres.

Toujours à l'aide de masques de dépôt, on dépose ensuite sur la première couche conductrice 31 des éléments isolants de la couche tampon 32, à l'endroit de chaque diode. Les masques utilisés sont adaptés pour que :
- le positionnement et la surface des éléments de la couche tampon 32 couvrent à nouveau l'ensemble de la surface des électrodes inférieures 15 dégagées par les fenêtres pratiquées dans la couche isolante 13 ;
- la surface des éléments isolants de la couche tampon 32 soit suffisamment petite pour ménager entre les diodes, c'est à dire entre des lignes et/ou entre des colonnes, de larges zones non couvertes de la surface de la première couche conductrice 31.

A cet effet, on peut utiliser les mêmes masques que pour le dépôt des couches organiques, ce qui nécessite trois opérations de dépôt ; on peut également utiliser un masque spécifique qui permet de réaliser le dépôt en une seule opération ; ce masque peut présenter des ouvertures recouvrant plusieurs diodes, voire même des colonnes ou des lignes entières de diodes ; dans le cas d'un masque ne présentant qu'une ouverture par diode, cette ouverture peut être plus grande ou plus petite que celle utilisée pour le dépôt des couches organiques, selon la zone de couche organique que l'on souhaite protéger.

Pour ces éléments de la couche tampon 32, on choisit un matériau électriquement isolant et transparent adapté pour obtenir une protection efficace des couches organiques 2, 2' lors du dépôt ultérieur de la deuxième couche conductrice. L'épaisseur des éléments de la couche tampon 32 est également adaptée à cet effet, sans risque ici de voir la transparence diminuer puisque le matériau utilisé est transparent. On entend par matériau transparent un matériau transmettant une partie au moins du spectre d'émission électroluminescente de la couche organique qu'il recouvre. Selon une variante de l'invention, ce matériau peut également servir de filtre optique, notamment pour adapter le spectre d'émission et la colorimétrie des diodes.

Il importe également que le matériau choisi pour ces éléments de la couche tampon 32 puisse être déposé sans risque de détérioration des couches organiques sous-jacentes 2, 2'.

Comme matériau pour ces éléments de la couche tampon 32, on choisit de préférence une matériau minéral, qui apporte une meilleure protection des couches organiques sous-jacentes qu'un matériau organique ; de préférence, on choisit un matériau qui puisse se déposer dans des conditions dites « douces » ne risquant pas de dégrader les couches organiques sous-jacentes, c'est à dire un matériau qui, pour son dépôt, ne nécessite pas de température de substrat supérieure à 50°C et dont l'énergie des particules qui se posent sur le substrat est, lors du dépôt, inférieure à 100 eV ; de préférence, on choisit un matériau présentant un indice de réfraction supérieur à 2 pour améliorer le taux d'extraction de lumière de l'électrode supérieure.

Comme matériau pour les éléments de la couche tampon 32, on choisit ainsi de préférence un oxyde de silicium de formule SiOx, où 0 < x ≤ 2, ou un nitrure de silicium SiNy' où 0 < y ≤ 1,33, ou un oxynitrure de silicium, ou encore un oxyde de tantale TaOz . De préférence, les valeurs des indices x, y ou z sont adaptées d'une manière connue en elle-même pour que le matériau tampon présente un indice de réfraction supérieur à 2. On choisit ainsi de préférence le séléniure de zinc (ZnSe) dont l'indice de réfraction est supérieur à 2 et qui présente en outre l'avantage d'être facilement évaporable thermiquement.

D'autres matériaux inorganiques isolants et transparents peuvent être utilisés pour la couche tampon 32 sans se départir de l'invention, comme des halogénures ou chal-cogénures d'éléments alcalins ou alcalino-terreux.

L'épaisseur de la couche tampon est adaptée d'une manière connue en elle-même pour obtenir le niveau de protection souhaité, eu égard aux risques de dégradation des couches organiques sous-jacentes ; en pratique, on aboutira généralement à des épaisseurs supérieures à 20 nm ; en pratique, la conductivité surfacique de cette couche tampon sera alors inférieure à la conductivité surfacique de la deuxième couche conductrice 33, déposée ultérieurement, ce qui rend nécessaire les zones de contact direct selon l'invention entre les deux couches conductrices de l'électrode supérieure ; de préférence, la conductivité surfacique de cette couche tampon sera inférieure à un dixième de la conductivité surfacique de la deuxième couche conductrice 33.

Après le dépôt des éléments de la couche tampon 32, on procède au dépôt d'une deuxième pleine couche conductrice 33 d'épaisseur supérieure à 20 nm, de manière à recouvrir l'ensemble de la surface active du substrat. Cette deuxième couche conductrice est également continue, d'épaisseur approximativement homogène, et sans trous intentionnels ni fenêtres.

Grâce à la protection apportée par les éléments de la couche tampon 32, on peut utiliser des méthodes de dépôt à haute énergie sans risque de dégrader les couches organiques sous-jacentes.

De préférence, pour cette deuxième couche conductrice 33, on utilise un matériau à base d'ITO ou d'IZO, déposé par pulvérisation cathodique sous vide.

Comme l'illustre la figure 1, les larges zones non couvertes par les éléments de la couche tampon 32 de la surface de la première couche conductrice 31 sont directement au contact de cette deuxième couche conductrice 33 ; ces zones sont donc des zones de contact 4.

La première couche conductrice 31, la couche tampon 32 et la deuxième couche conductrice 33 forment donc ici une électrode supérieure 3 qui est commune à l'ensemble des diodes du panneau supportées par le substrat 1.

La deuxième couche conductrice 33 de cette électrode supérieure est destinée à distribuer le courant d'alimentation à chacune des diodes via la première couche conductrice 32 et les zones de contact 4 entre ces couches, qui correspondent aux fenêtres ou ouvertures dans la couche tampon 32..

De préférence, l'épaisseur de la deuxième couche conductrice 33 est supérieure à celle de la première couche conductrice 31. De préférence, l'épaisseur de la deuxième couche conductrice 33 est adaptée pour que la conductivité surfacique de cette couche soit au moins dix fois supérieure à celle de la première couche 31, ce qui permet d'assurer une distribution efficace et homogène du courant électrique d'alimentation des diodes.

On obtient ainsi un panneau de diodes électroluminescentes selon l'invention. Chaque diode 5, 5' de ce panneau présente une surface émissive qui correspond à une zone de recouvrement de son électrode inférieure 15 par l'électrode supérieure 3, qui est transparente dans cette zone à la lumière émise par cette diode, et qui comprend :
- dans cette zone, et entre ces électrodes, une couche organique électroluminescente 2, 2' ;
- dans cette zone, et entre la première 31 et la deuxième 33 couche conductrice de l'électrode supérieure 3, un élément de la couche tampon 32, qui est isolant et transparent.

La conductivité surfacique des éléments isolants de la couche tampon 32 est généralement inférieure à un dixième de celle de la première couche conductrice.

Sans se départir de l'invention, les éléments de la couche tampon peuvent être distribués en plots disjoints, un par diode, ou un élément pour une ensemble de diodes, ou en bandes continues recouvrant chacune une ligne ou une colonne de diodes, ou d'autres configurations, du moment que la disposition de ces éléments de la couche tampon ménage entre des diodes des zones de contact de surface suffisante pour assurer efficacement et uniformément la distribution du courant comme précédemment décrit. Sans se départir de l'invention, au lieu de déposer des éléments disjoints de couche tampon comme précédemment décrit, on peut également envisager de déposer une couche tampon « pleine couche » dotée de fenêtres débouchant entre les diodes pour ménager des zones de contact direct avec la première couche de contact 31.

La présente invention a été décrite en se référant à un panneau électroluminescent à matrice active ; il est évident pour l'homme du l'art qu'elle peut s'appliquer à d'autres types de panneaux d'affichage ou d'éclairage, notamment des panneaux à matrice passive, sans sortir du cadre des revendications ci-après. Dans le cas de matrice passive, chaque électrode inférieure est généralement commune à une rangée de diodes, et chaque électrode supérieure est généralement commune à une colonne de diodes, ou vice-versa. L'invention s'applique aussi bien aux cas où les électrodes inférieures sont des anodes et les électrodes supérieures des cathodes, qu'aux cas inverses où les électrodes inférieures sont des cathodes et les électrodes supérieures des anodes.

## Revendications

1. Panneau d'éclairage ou d'affichage d'images comprenant un réseau de diodes organiques électroluminescentes (5, 5') supportées par un substrat (1), au moins un réseau d'électrodes inférieures (15) au contact du substrat et un réseau d'électrodes supérieures (3),
où chaque diode (5, 5') comprend une couche organique électroluminescente (2, 2') qui est intercalée entre une électrode inférieure (15) et une électrode supérieure (3), qui elle-même est transparente à la lumière émise par cette diode,
où au moins une (3) desdites électrodes supérieures est commune à une pluralité de diodes (5, 5') et comprend une première couche conductrice (31) au contact de la couche organique électroluminescente (2, 2') et une deuxième couche conductrice (33), et une couche tampon transparente (32) intercalée entre ces deux couches conductrices (31, 33),
**caractérisé en ce que**, pour chaque dite électrode supérieure (3) commune à une pluralité de diodes, ladite couche tampon (32) est percée de fenêtres qui ménagent des zones de contact direct (4) entre la première et la deuxième couches conductrices (31, 33) de cette électrode commune (3).

2. Panneau selon la revendication 1 **caractérisé en ce que**, la zone active de chaque diode étant définie comme la zone de superposition de l'électrode inférieure et de l'électrode supérieure de cette diode, pour chaque dite électrode supérieure (3), lesdites zones de contact direct (4) ne se superposent avec aucune zone active des diodes ayant ladite électrode supérieure en commun.

3. Panneau selon l'une quelconque des revendications précédentes **caractérisé en ce que**, pour chaque dite électrode supérieure (3), la conductivité surfacique de ladite deuxième couche conductrice (33) est supérieure à la conductivité surfacique de ladite première couche conductrice (31), et la conductivité surfacique de ladite couche tampon est inférieure à un dixième de la conductivité surfacique de la deuxième couche conductrice (33) de ladite dite électrode supérieure (3).

4. Panneau selon l'une quelconque des revendications précédentes **caractérisé en ce que**, pour chaque dite électrode supérieure (3) commune, le matériau de ladite couche tampon est choisi dans le groupe formé par l'oxyde, le nitrure, et l'oxy-nitrure de silicium, et l'oxyde de tantale.

5. Panneau selon l'une quelconque des revendications précédentes **caractérisé en ce que**, pour chaque dite électrode supérieure (3) commune, le matériau de ladite seconde couche conductrice (33) est à base d'oxyde.

6. Panneau selon la revendication 5 **caractérisé en ce que** ledit oxyde est choisi dans le groupe formé par l'oxyde mixte d'Indium et d'étain (ITO) et l'oxyde mixte d'Indium et de Zinc (IZO).

7. Panneau selon la revendication 5 ou 6 **caractérisé en ce que** l'épaisseur de ladite deuxième couche conductrice (33) est supérieure ou égale à 100 nm.

8. Panneau selon l'une quelconque des revendications précédentes **caractérisé en ce que**, pour chaque dite électrode supérieure (3) commune, le matériau de ladite première couche conductrice (31) est métallique.

9. Panneau selon la revendication 8, **caractérisé en ce que** l'épaisseur de ladite première couche conductrice (31) est supérieure à 1 nm et inférieure ou égale à 20 nm.

10. Panneau selon l'une quelconque des revendications précédentes **caractérisé en ce que**, pour chaque dite électrode supérieure (3) commune, l'épaisseur de ladite deuxième couche conductrice (33) est supérieure à l'épaisseur de ladite première couche conductrice (31).

## Claims

1. Panel for illuminating or displaying images comprising a network of organic light-emitting diodes (5, 5') supported by a substrate (1), at least one lower network of electrodes (15) in contact with the substrate and one upper network of electrodes (3),
where each diode (5, 5') comprises an organic light emitting layer (2, 2') that is interposed between a lower electrode (15) and an upper electrode (3), that itself is transparent to the light emitted by this diode,
where at least one (3) of said upper electrodes is common to a plurality of diodes (5, 5') and comprises a first conductive layer (31) in contact with the organic light emitting layer (2, 2') and a second conductive layer (33), and a transparent buffer layer (32) interposed between these two conductive layers (31, 33),
**characterized in that**, for each said upper electrode (3) common to a plurality of diodes, said buffer layer (32) is drilled with windows that allow direct contact zones (4) between the first and second conductive layers (31, 33) of this common electrode (3).

2. Panel according to claim 1, **characterized in that** the active zone of each diode being defined as the overlay zone of the lower electrode and the upper electrode of this diode, for each said upper electrode (3), said direct contact zones (4) do not overlay any active zone of the diodes having said upper electrode in common.

3. Panel according to any one of the preceding claims, **characterized in that** for each said upper electrode (3), the surface conductivity of said second conductive layer (33) is greater than the surface conductivity of said first conductive layer (31), and the surface conductivity of said buffer layer is less than a tenth of the surface conductivity of the second conductive layer (33) of said upper electrode (3).

4. Panel according to any one of the preceding claims, **characterized in that** for each said common upper electrode (3), the material of said buffer layer is selected in the group formed by the oxide, silicon oxy-nitride and tantalum-oxide.

5. Panel according to any one of the preceding claims, **characterized in that** for each said common upper electrode (3), the material of said second conductive layer (33) is oxide based.

6. Panel according to claim 5, **characterized in that** said oxide is selected in the group formed by mixed Indium and Tin Oxide (ITO) and mixed Indium and Zinc Oxide (IZO).

7. Panel according to claim 5 or 6, **characterized in that** the thickness of said second conductive layer (33) is greater than or equal to 100 nm.

8. Panel according to any one of the preceding claims, **characterized in that** for each said common upper electrode (3), the material of said first conductive layer (31) is metallic.

9. Panel according to claim 8, **characterized in that** the thickness of said first conductive layer (31) is greater than 1 nm and less than or equal to 20 nm.

10. Panel according to any one of the preceding claims, **characterized in that** for each said common upper electrode (3), the thickness of said second conductive layer (33) is greater than the thickness of said first conductive layer (31).

## Patentansprüche

1. Beleuchtungs- oder Bildanzeigeschirm mit einem Gitter aus von einem Substrat (1) getragenen elektrolumineszenten organischen Dioden (5, 5'), mindestens einem Gitter aus unteren Elektroden (15) in Kontakt mit dem Substrat und einem Gitter aus oberen Elektroden (3), bei dem
- jede Diode (5, 5') eine elektrolumineszente organische Schicht (2, 2') aufweist, die zwischen einer unteren Elektrode (15) und einer oberen Elektrode (3), welche selbst für das von dieser Diode emittierte Licht durchsichtig ist, angeordnet ist,
- mindestens eine (3) der oberen Elektroden einer Vielzahl von Dioden (5, 5') gemeinsam ist und eine erste leitende Schicht (31) in Kontakt mit der elektrolumineszenten organischen Schicht (2, 2') und eine zweite leitende Schicht (33) und eine transparente, zwischen diesen zwei leitenden Schichten (31, 33) angeordnete Pufferschicht (32) umfasst, **dadurch gekennzeichnet, dass** bei jeder einer Vielzahl von Dioden gemeinsamen oberen Elektrode (3) die Pufferschicht (32) mit Fenstern durchbrochen ist, die Bereiche mit direktem Kontakt (4) zwischen der ersten und der zweiten leitenden Schicht (31, 33) dieser gemeinsamen Elektrode (3) bilden.

2. Beleuchtungs- oder Bildanzeigeschirm nach Anspruch 1, **dadurch gekennzeichnet, dass** der aktive Bereich jeder Diode als der Bereich definiert ist, in dem sich bei jeder oberen Elektrode (3) die untere Elektrode und die obere Elektrode dieser Diode überlagern, wobei die Bereiche direkten Kontakts (4) sich mit keinem aktiven Bereich der Dioden, denen die obere Elektrode gemeinsam ist, überlagern.

3. Beleuchtungs- oder Bildanzeigeschirm nach einem der vorstehenden Ansprüche, **dadurch gekennzeichnet, dass** bei jeder oberen Elektrode (3) die Oberflächenleitfähigkeit der zweiten leitenden Schicht (33) die Oberflächenleitfähigkeit der ersten leitenden Schicht (31) übersteigt und die Oberflächenleitfähigkeit der Pufferschicht geringer ist als ein Zehntel der Oberflächenleitfähigkeit der zweiten leitenden Schicht (33) der oberen Elektrode (3).

4. Beleuchtungs- oder Bildanzeigeschirm nach einem der vorstehenden Ansprüche, **dadurch gekennzeichnet, dass** bei jeder gemeinsamen oberen Elektrode (3) das Material der Pufferschicht aus der Gruppe aus Oxid, Nitrid, Silicium-Oxinitrid und Tantaloxid gewählt ist.

5. Beleuchtungs- oder Bildanzeigeschirm nach einem der vorstehenden Ansprüche, **dadurch gekennzeichnet, dass** bei jeder gemeinsamen oberen Elektrode (3) das Material der zweiten leitenden Schicht (33) auf Oxidbasis ist.

6. Beleuchtungs- oder Bildanzeigeschirm nach Anspruch 5, **dadurch gekennzeichnet, dass** das Oxid aus der Gruppe aus Mischoxid aus Indium und Zinn (ITO) und Mischoxid aus Indium und Zink (IZO) gewählt ist.

7. Beleuchtungs- oder Bildanzeigeschirm nach Anspruch 5 oder 6, **dadurch gekennzeichnet, dass** die Dicke der zweiten leitenden Schicht (33) größer als oder gleich 100 nm ist.

8. Beleuchtungs- oder Bildanzeigeschirm nach einem der vorstehenden Ansprüche, **dadurch gekennzeichnet, dass** bei jeder gemeinsamen oberen Elektrode (3) das Material der ersten leitenden Schicht (31) metallisch ist.

9. Beleuchtungs- oder Bildanzeigeschirm nach Anspruch 8, **dadurch gekennzeichnet, dass** die Dicke der ersten leitenden Schicht (31) größer als 1 nm und kleiner als oder gleich 20 nm ist.

10. Beleuchtungs- oder Bildanzeigeschirm nach einem der vorstehenden Ansprüche, **dadurch gekennzeichnet, dass** bei jeder gemeinsamen oberen Elektrode (3) die Dicke der zweiten leitenden Schicht (33) größer als die Dicke der ersten leitenden Schicht (31) ist.
